(19)

Europäisches
Patentamt
European
Patent Office
Office européen
des brevets

(11) **EP 3 527 689 A1**

(12) **EUROPEAN PATENT APPLICATION**
published in accordance with Art. 153(4) EPC

(43) Date of publication:
**21.08.2019 Bulletin 2019/34**

(21) Application number: **17901157.2**

(22) Date of filing: **06.12.2017**

(51) Int Cl.:
***C23C 14/34*** (2006.01)　　　***C04B 35/111*** (2006.01)

(86) International application number:
**PCT/JP2017/043730**

(87) International publication number:
**WO 2018/168111 (20.09.2018 Gazette 2018/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(30) Priority: **15.03.2017　JP 2017049874**

(71) Applicant: **JX Nippon Mining & Metals Corporation
Tokyo 100-8164 (JP)**

(72) Inventor: **KOIDO Yoshimasa
Kitaibaraki-shi
Ibaraki 319-1535 (JP)**

(74) Representative: **Cornford, James Robert
Forresters IP LLP
Skygarden
Erika-Mann-Strasse 11
80636 München (DE)**

(54) **AL2O3 SPUTTERING TARGET AND METHOD FOR PRODUCING SAME**

(57)　An $Al_2O_3$ sputtering target having a purity of 99.99 wt% or higher, a relative density of 85% or higher and 95% or less, a volume resistivity of $10 \times 10^{14}$ $\Omega \cdot cm$ or less, and a dielectric tangent of $15 \times 10^{-4}$ or more. An object of the present invention is to provide an $Al_2O_3$ sputtering target having favorable sputtering characteristics, and in particular an $Al_2O_3$ sputtering target and a production method thereof capable of increasing the deposition rate without having to increase the sputtering power.

EP 3 527 689 A1

**Description**

TECHNICAL FIELD

The present invention relates to an $Al_2O_3$ sputtering target and its production method suitable for forming, for instance, semiconductor elements such as gate insulation films, masks, and etch stoppers.

BACKGROUND ART

In recent years, NAND flash memories have undergone considerable capacity enlargement due to their broadness of usage and low price, and, in comparison to logic, DRAM and other memories, technologies of miniaturization and three-dimensional structuring have advanced and their structures are becoming even more complex. A NAND flash memory is configured by stacking thin films having functional elements and thin films for structure formation, and the use of an $Al_2O_3$ thin film is being considered as an etch stopper upon stacking the thin films. As the method of forming thin films, a so-called physical vapor deposition method such as the vacuum deposition method or the sputtering method is generally used. Thin films are often formed by using a magnetron sputtering method particularly in light of operability and deposition stability.

The formation of thin films based on the sputtering method is performed by physically colliding positive ions of argon ions to the target placed on a cathode, discharging the collision energy thereof to the material configuring the target, and depositing a film, which has a composition that is substantially the same as the target material, on the substrate facing the cathode. Deposition based on the sputtering method is characterized in being able to form films having range from thin films of angstrom units to thick films of several ten $\mu$m at a stable deposition rate by adjusting the processing time and the supplied power. In particular, because oxides do not possess conductivity and cannot be sputtered with the sputtering method using a general DC power source, the sputtering method using an RF power source is often used.

When RF-sputtering a compound film of $Al_2O_3$ or the like as an insulator, what is particularly problematic is the deposition rate. In comparison to DC sputtering, because a negative voltage is applied to the target surface as an insulator in RF sputtering, positive voltage and negative voltage are alternately applied continuously. Thus, deposition cannot be performed continuously as with DC sputtering, and this causes the deterioration in the deposition rate. Moreover, the fact that the atoms to each other are bonded through strong covalent bonding and not metallic bonding is also a factor that causes the deterioration in the deposition rate. And these problems are a major cause in deteriorating the productivity.

Meanwhile, while considered may be increasing the sputtering power to improve the productivity, when the power is increased, there is a problem in that the sputtering target often cracked. To deal with this problem, Patent Document 1 discloses a sputtering target using an alumina sintered body having a high strength capable of withstanding high power for increasing the deposition rate, an average crystal grain size of 5 $\mu$m or more and 20 $\mu$m or less, and a porosity of 0.3% or higher and 1.5% or less. Moreover, Patent Document 1 additionally discloses a method of producing an alumina sputtering target including the steps of performing pressure molding to the alumina raw material powder, and calcinating the obtained compact in a hydrogen atmosphere.

Patent Document 2 discloses a sputtering target using a high density, high quality alumina sintered body having a purity of 99.99 mass% or higher, a relative density of 98% or higher, and an average crystal grain size of less than 5 $\mu$m. Moreover, as the production method thereof, Patent Document 2 describes performing hot press sintering at 1250 to 1350°C to obtain a sintered body, and performing annealing treatment thereto at 1300 to 1700°C in the atmosphere to produce a target.

As described above, conventionally, in order to prevent the sputtering target from cracking, the mechanical strength of the target was improved by adjusting the density and the grain size.

CITATION LIST

PATENT DOCUMENTS

[Patent Document 1] Japanese Unexamined Patent Application Publication No. 2000-64034
[Patent Document 2] International Publication No. WO2013/065337

## SUMMARY OF INVENTION

### TECHNICAL PROBLEM

An object of an embodiment of the present invention is to provide an $Al_2O_3$ sputtering target capable of increasing the deposition rate without having to increase the sputtering power, as well as the production method thereof.

### SOLUTION TO PROBLEM

In order to achieve the foregoing object, as a result of intense study, the present inventors discovered that the electrical characteristics of the sputtering target, in particular the control of the volume resistivity and the dielectric tangent, are effective for improving the deposition rate, and discovered that, by controlling these characteristics within a predetermined range, the RF application can be efficiently performed and the deposition rate can be improved.

The $Al_2O_3$ sputtering target according to an embodiment of the present invention has a purity of 99.99 wt% or higher, a relative density of 85% or higher and 95% or less, a volume resistivity of $10 \times 10^{14}$ $\Omega \cdot$cm or less, and a dielectric tangent of $15 \times 10^{-4}$ or more.

### ADVANTAGEOUS EFFECTS OF INVENTION

According to an embodiment of the present invention, the $Al_2O_3$ sputtering target yields a superior effect of being able to realize a high deposition rate and improve the productivity without having to increase the sputtering power.

### BRIEF DESCRIPTION OF DRAWINGS

Fig. 1 is a diagram showing the measurement points in a sputtering target of the present invention.
Fig. 2 is a diagram showing the measurement points of the film thickness deposited on the wafer of the present invention.

### DESCRIPTION OF EMBODIMENTS

The $Al_2O_3$ sputtering target according to an embodiment of the present invention is used for forming thin films having the function of semiconductor elements and forming thin films for structure formation, and the purity is set to 99.99 wt% (4N) or higher to suppress the deterioration in film characteristics. Here, the expression of "purity of 99.99 wt% or higher" means that, based on GDMS analysis, the total content of Ca, Fe, K, Mg, and Na as relatively large amounts of impurity elements contained in $Al_2O_3$ is less than 100 wtppm. Because these impurity elements sometimes deteriorate the film characteristics such as corrosion resistance, it is preferable to reduce the impurity elements as much as possible.

An embodiment of the present invention is characterized in that, in an $Al_2O_3$ sputtering target having a purity of 99.99 wt% or higher, the volume resistivity is $10 \times 10^{14}$ $\Omega \cdot$cm or less, and the dielectric tangent is $15 \times 10^{-4}$ or more. By adjusting the electrical characteristics of the sputtering target to be within the foregoing range, the radio frequency voltage can be efficiently applied during RF (radio frequency) sputtering, the deposition rate can be increased without having to increase the sputtering power, and the productivity of the product can be improved. Furthermore, this will contribute to the inhibition of the generation of particles, stability of the film thickness, and shortening of the burn-in time.

In RF sputtering, while it is necessary to cause the surface to be negatively charged in order to draw the positive ions to the target surface, by causing the volume resistivity of the target to be $10 \times 10^{14}$ $\Omega \cdot$cm or less, it is possible to achieve a moderate charged state. Meanwhile, in RF sputtering, because a positive voltage and a negative voltage are alternately applied, the charge needs to be moderately released after the negative voltage is applied. However, because it is difficult to release the charge when the loss is small as with a general ceramic condenser; that is, when the dielectric tangent is small at roughly $1.0 \times 10^{-4}$, it is not possible to apply the voltage efficiently. Thus, in the present invention, the charge can be efficiently released by adjusting the dielectric tangent of the target to be $15 \times 10^{-4}$ or more, and RF sputtering can thereby be effectively performed. Note that the lower limit value of the volume resistivity is preferably set to be $1 \times 10^{14}$ $\Omega \cdot$cm or more, and the upper limit value of the dielectric tangent is preferably set to be $360 \times 10^{-4}$ or less.

Moreover, the $Al_2O_3$ sputtering target according to an embodiment of the present invention is characterized in having a relative density of 95% or less. When the relative density is 95% or less, hollow walls will exist in the structure to a certain extent and the charge can be more easily released from those hollow walls, the foregoing dielectric tangent can thereby be achieved, and the deposition rate can consequently be improved. Meanwhile, when the relative density is too low, pores included in the target will increase and cracks may arise in the target, and therefore the relative density is preferably set to be 85% or higher.

The relative density is calculated as follows: relative density (%) = measured density/theoretical density × 100. The measured density is calculated from (weight of sample)/(volume of sample) by measuring the length of the sample by using a caliper. Moreover, the theoretical density of $Al_2O_3$ is 3.98 g/cm$^3$.

Moreover, the sputtering target according to an embodiment of the present invention is characterized in having an average crystal grain size of 0.3 $\mu$m or more and 3.0 $\mu$m or less. By causing the average crystal grain size to be 3.0 $\mu$m or less, it is possible to suppress the variation in the film thickness and cause the film thickness stability to be favorable. Meanwhile, the average crystal grain size of the target depends on the grain size and sintering conditions of the raw material powder, and the average crystal grain size that can be achieved with the production method described later is 0.3 $\mu$m or more. Note that, because the average crystal grain size of the target will change also depending on the sintering conditions in addition to the grain size of the raw material powder, it is necessary to adjust the mutual conditions.

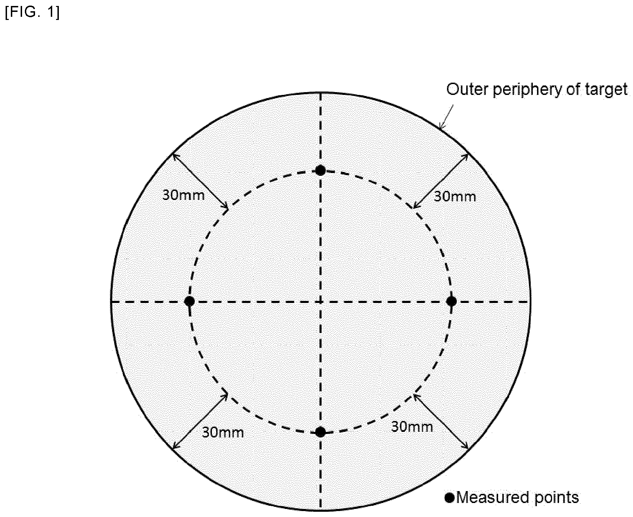

The average crystal grain size is obtained by observing 4 points (Fig.1) of a plane that is parallel to the sputter surface of the target using a Scanning Electron Microscope (SEM) at a visual field of 2000X, and measuring the crystal grain size in the respective visual fields based on an evaluation method according to the cutting method of JIS G0551. Subsequently, the average value of the four visual fields is used as the average crystal grain size. Note that the term "sputter surface" refers to the surface facing the substrate to which ions of argon or the like collide and grains configuring the target pop out, in the sputtering process.

Moreover, the $Al_2O_3$ sputtering target according to an embodiment of the present invention is characterized in that the surface roughness Ra of the sputter surface is 1.0 $\mu$m or more and 2.0 $\mu$m or less. Normally, when the sputtering target is used in a production line, pre-sputtering (burn-in) is performed to stabilize the characteristics of the target. Here, because the surface roughness Ra after the completion of the burn-in is 1.0 $\mu$m to 2.0 $\mu$m, the burn-in time can be shortened by causing the surface roughness Ra in advance to be close to the foregoing numerical value, that is the value after the completion of the burn-in.

The surface roughness of the present invention is measured at the 4 points shown in Fig. 1 based on stylus surface roughness measurement (JIS B0601), and the average value of the respective measured values is used as the surface roughness.

Moreover, the $Al_2O_3$ sputtering target according to an embodiment of the present invention is characterized in that the transverse intensity is 200 MPa or more. Normally, when the density of the sputtering target is low, due to the increase of pores, in certain cases the strength will deteriorate and cracks and fractures may arise in the target during sputtering. Nevertheless, even when the relative density of the target is 95% or less, by causing the transverse intensity to be 200 MPa or more, it is possible to effectively prevent the occurrence of cracks and fractions in the target during sputtering.

The transverse intensity of the present invention is measured at the 4 points shown in Fig. 1 based on 3-point bending (JIS R1601), and the average value of the respective measured values is used as the transverse intensity.

The production method of the $Al_2O_3$ sputtering target according to an embodiment of the present invention is now explained.

An $Al_2O_3$ powder having a purity of 99.99 wt% or higher is prepared. It is preferable that the average grain size of the $Al_2O_3$ powder is 0.1 to 0.3 $\mu$m. The average grain size of 0.1 to 0.3 $\mu$m is the optimal grain size in the subsequent sintering process, and, upon deviating from this range, it becomes difficult to control the relative density and the average crystal grain size of the target to fall within the foregoing intended range.

The grain size of the raw material powder is measured by using a laser diffraction/scattering-type grain size distribution measurement device in which isopropyl alcohol is used as a dispersion medium, and, after performing ultrasonic dispersion for one minute, the grain size is measured and, among the measured data, $D_{50}$ is used as the average grain size.

Next, hot press molding is performed. The raw material powder is filled in a mold and thereafter hot pressed in a vacuum or inert gas atmosphere to prepare a compact. Here, when the density after the hot press is too low, even if the target (sintered body) characteristics are favorable, there may be cases where the film thickness stability will deteriorate. Meanwhile, when the density after the hot press is too high, it becomes difficult to increase the density in the subsequent atmospheric sintering. This is considered to be a phenomenon due to the difference between the hot press and the sintering behavior of the subsequent atmospheric sintering. In other words, when the density is low after the hot press, because the sintering will not advance and the necking of powders each other is also few, while sintering will further advance during atmospheric sintering, if sufficient density is increased in the hot press, the sintering will excessively advance and stabilize in that state, and, even if atmospheric sintering is subsequently performed, it is considered that it is difficult for the sintering to advance only based on heating. Accordingly, the relative density after the hot press is preferably set to 60% or higher and 85% or less.

The hot press temperature is preferably 800°C to 1400°C. Moreover, a binder or the like may be mixed with the raw material powder to facilitate molding, granulation may be performed with a spray dryer, and the granulated powder may be subsequently molded.

Next, the obtained compact is subject to pressureless sintering (atmospheric sintering) in an air atmosphere furnace. The temperature t (°C) in this atmospheric sintering shall be within a temperature range that satisfies $T \leq t \leq T + 600$ (°C) when the hot press temperature of the previous process is T(°C). For example, when the hot press temperature is 1200°C, the temperature range of sintering shall be 1200°C or higher and 1800°C or lower. The holding time of sintering is preferably set to 2 to 10 hours.

The conditions of this atmospheric sintering will considerably affect the density and crystal grain size of the final sputtering target. When the sintering temperature is high, the relative density will increase, and the grain size will also increase. Meanwhile, when the sintering temperature is low, the relative density of the target will decrease, and the grain size will also decrease. Accordingly, if the sintering conditions of the atmospheric sintering is not optimized in the relation of the density after the hot press; that is, the temperature of the hot press, the intended density and the crystal grain size cannot be obtained, and, due to the abnormal grain growth of crystals, variation in the grain size will become notable, and this is undesirable.

Next, the obtained sintered body is machined with a lathe or via surface grinding and the like, and processed into a target of the intended size and shape. Subsequently, the surface of the sintered body is roughened via rough grinding or blast treatment as needed to cause the surface roughness Ra to be 1.0 $\mu$m or more and 2.0 $\mu$m or less. It is thereby possible to prepare the $Al_2O_3$ sputtering target of the present invention.

The evaluation method and other matters of the present invention, including the Examples and Comparative Examples described later, are as follows.

(Volume resistivity)

The volume resistivity is measured by taking samples from four points in in-plane of the target (refer to Fig. 1) and measuring the resistivity of the surface that is horizontal to the sputter surface based on the DC three-terminal method, and then obtaining the average value thereof. The resistivity can be measured by using a digital ultra-high resistance/micro ammeter (model 5450) manufactured by ADC Corporation.

Specifically, a main electrode, a guard electrode, and a counter electrode are printed on the upper surface and the lower surface of the sample by using a screen printer and a silver paste, electrodes are formed by drying the same in the atmosphere at 100°C for 12 hours, a direct voltage (V = 1000 V) was subsequently applied to the sample, and the current (I) after 1 minute of charging is measured, and the volume resistivity (Rv) of the sample is thereby obtained. Subsequently, the thickness (t = 1.2 mm) and the electrode surface area (S = 1.85 cm$^2$) of the sample are introduced into the following formula to calculate the volume resistivity ($\rho$v).

$$\text{(Formula) volume resistivity: } \rho v = S/t \times Rv = (S/t) \times (V/I)$$

(Dielectric tangent)

The dielectric tangent is measured by taking samples from four in-plane points of the target as shown in Fig. 1 and measuring the respective dielectric tangents of the surface that is horizontal to the sputter surface based on the two-terminal method, and then obtaining the average value thereof. The impedance analyzer E4990A manufactured by Keysight Technologies is used for the foregoing measurement, and the dielectric tangent is obtained based on the automatic balance bridge method. The test conditions are a frequency of 1 MHz and room temperature.

(Evaluation method of sputtering characteristics)

A target is placed in a sputtering device equipped with an RF power source and a film is deposited under conditions of an input power of 2.5 to 3.0 W/cm$^2$, an Ar partial pressure of 0.5 Pa, and a film thickness of 500 Å. The deposition rate (depo rate) is calculated from (thickness of deposited film)/(time required for deposition). The deposition rate can be determined as being favorable if it is 4.0 Å/second or more.

The number of particles is checked by using a particle counter (CS920 manufactured by KLA Tencor) to count the number of particles in excess of 0.12 $\mu$m existing on a wafer having a diameter of 300 mm after deposition. The number of particles can be determined as being favorable if it is less than 100 particles. Moreover, the burn-in time is the time that is required for the deposition rate to reach 3.7 Å/second. The burn-in time can be determined as being favorable if it is within 200 kwh.

(Evaluation method of film characteristics)

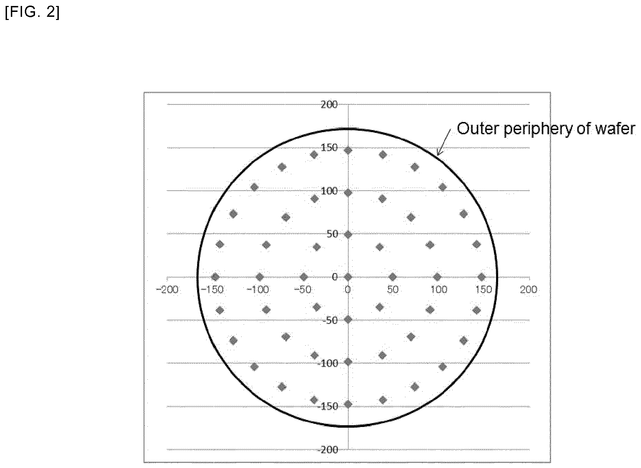

A target is placed in a sputtering device equipped with an RF power source and a film is deposited under conditions of an input power of 2.5 to 3.0 $W/cm^2$, an Ar partial pressure of 0.5 Pa, and a film thickness of 500 Å. The film thickness stability is measured by measuring the film thickness of 49 points in in-plane of the wafer (refer to Fig. 2) after a film is deposited on a wafer having a diameter of 300 mm, and thereby obtaining the film thickness distribution, and the degree of variation ($\sigma$) is evaluated based on 3 levels (◎: $\sigma < 10$ Å; ○: $10$ Å $\leq \sigma \leq 30$ Å; $\Delta$: $30$ Å $< \sigma$).

Moreover, with regard to the etching resistance, dry etching is performed to the $Al_2O_3$ film that is deposited on a wafer having a diameter of 300 mm, and the etching amount in the depth direction was measured based on SEM. The etching rate can be determined as being favorable if the calculated etching rate is 20 nm/min or less.

EXAMPLES

The Examples of the present invention and the Comparative Examples are now explained. Note that the following Examples merely illustrate representative examples, and it should be understood that the present invention is not limited to these Examples, and the present invention should be interpreted within the technical scope described in this specification.

(Example 1)

An $Al_2O_3$ raw material powder having a purity of 99.99 wt% or higher was prepared, and the grain size was adjusted so that the average grain size will be 0.2 $\mu$m. Next, the powder was filled in a mold and hot pressed in a vacuum, and the hot press conditions were set so that the relative density of the sintered body after the hot press will be 60% or higher. Next, the sintered body was subject to pressureless sintering (atmospheric sintering) in an air atmosphere furnace. The atmospheric sintering temperature was set to be the same as the hot press temperature. The thus obtained sintered body was subject to machining and polishing to prepare a sputtering target.

The thus obtained sputtering target contained 1 wtppm of Ca, 3 wtppm of Fe, 4 wtppm of K, 2 wtppm of Mg and 7 wtppm of Na, wherein a total content thereof was less than 100 wtppm, and possessed the following intended characteristics; specifically, a volume resistivity of $1.3 \times 10^{14}$ $\Omega$cm, a dielectric tangent of $300 \times 10^{-4}$, a relative density of 85.1%, a surface roughness Ra of 1.3 $\mu$m, and a transverse intensity of 250 MPa.

Moreover, as a result of checking the sputtering characteristics and the thin film characteristics regarding the sputtering target, the following favorable results were obtained; specifically, a deposition rate of 4.5 Å/second, a burn-in time of 50 kwh and a number of particles of 47 particles, and film thickness stability and etching resistance also yielded superior results. The foregoing results are shown in Table 1.

[Table 1]

(Examples 2 to 10)

In Examples 2 to 10, a sputtering target was prepared by adjusting, as needed, the density of the sintered body after hot press and the temperature ($\Delta$T) during atmospheric sintering, based on the production method of Example 1 described above (refer to Table 1). Consequently, as shown in Table 1, the characteristics of the target are within the intended range, and sputtering characteristics and film characteristics also exhibited favorable results.

Note that, in Example 8, as a result of setting the density of the sintered body after hot press to be low at 58.7%, and, while the film thickness stability decreased slightly, the deposition rate was favorable (4.0 Å/sec or more), no fractures could be found in the target after sputtering, and the target was usable as a product.

As a result of setting the surface roughness Ra of the target to be relatively rough at 2.2 $\mu$m in Example 9 and setting the surface roughness Ra of the target to be relatively smooth at 0.7 $\mu$m in Example 10, while the number of particles increased slightly in Example 9 and the burn-in time increased slightly in Example 10, the deposition rate was favorable (4.0 Å/sec or more) in both cases, no fractures could be found in the target after sputtering, and the target was usable as a product.

(Comparative Example 1)

A sputtering target was prepared based on the production method of Example 1 described above by adjusting the temperature so that the density of the sintered body after hot press will decrease and setting the temperature ($\Delta$T) in the subsequent pressureless sintering to 700°C. Consequently, as shown in Table 1, the volume resistivity, dielectric tangent, and relative density of the target deviated from the range of the present invention.

As a result of checking the sputtering characteristics of the sputtering target, the deposition rate was 3.7 Å/sec and slower than 4.0 Å/sec as the reference of a favorable deposition rate, and the film thickness stability was also inferior.

(Comparative Example 2)

An $Al_2O_3$ raw material powder having a purity of 99.99 wt% or higher was prepared, and the grain size was adjusted so that the average grain size will be 0.2 $\mu$m. Next, the powder was filled in a mold and hot pressed in a vacuum, and the hot press conditions were set so that the relative density of the sintered body after the hot press will be 92.5% or higher. Note that atmospheric sintering was not performed. Next, the thus obtained sintered body was subject to machining and polishing to prepare a sputtering target. The thus obtained sputtering target had a volume resistivity of $2.7 \times 10^{16}$ Ωcm, and a dielectric tangent of $15 \times 10^{-4}$.

As a result of checking the sputtering characteristics of the sputtering target, the deposition rate was 3.0 Å/second and slower than 4.0 Å/sec as the reference of a favorable deposition rate, and, because the deposition rate did not reach 3.7 Å/second even when sputtering was performed up to 200 kwh, the evaluation was ended here, and the subsequent evaluation (number of particles, film thickness stability, etching resistance) was not performed.

(Comparative Example 3)

An $Al_2O_3$ raw material powder having a purity of 99.99 wt% or higher was prepared, and the grain size was adjusted so that the average grain size will be 0.2 $\mu$m. Next, the powder was molded and the obtained compact was subject to pressureless sintering (atmospheric sintering) in an air atmosphere furnace. The atmospheric sintering temperature was set to 1200°C. Next, the thus obtained sintered body was subject to machining and polishing to prepare a sputtering target.

The thus obtained sputtering target had a volume resistivity of $8.2 \times 10^{15}$ Qcm, and a dielectric tangent of $12 \times 10^{-4}$.

As a result of checking the sputtering characteristics of the sputtering target, the deposition rate was 3.2 Å/second and slower than 4.0 Å/sec as the reference of a favorable deposition rate, and, because the deposition rate did not reach 3.7 Å/second even when sputtering was performed up to 200 kwh, the evaluation was ended here, and the subsequent evaluation (number of particles, film thickness stability, etching resistance) was not performed.

(Comparative Example 4)

A sputtering target was prepared based on the production method of Example 1 described above by adjusting, as needed, the density of the sintered body after hot press and the temperature ($\Delta$T) during atmospheric sintering. However, in Comparative Example 2, an $Al_2O_3$ raw material powder having a purity of 99.9 wt% or higher was used. Consequently, as shown in Table 1, the purity of the target deviated from the range of the present invention, and the etching resistance was inferior due to the existence of impurities.

(Comparative Example 5)

A sputtering target was prepared based on the production method of Example 1 described above by adjusting the temperature so that the density of the sintered body after hot press will increase and setting the temperature in the subsequent atmospheric sintering to 700°C. Consequently, as shown in Table 1, the relative density, average crystal grain size, and transverse intensity of the target deviated from the range of the present invention, and fractures were found in the target after sputtering.

INDUSTRIAL APPLICABILITY

The $Al_2O_3$ sputtering target of the present invention yields a superior effect of being able to realize a high deposition rate and improve the productivity, in RF sputtering. By using the $Al_2O_3$ sputtering target of the present invention, it is possible to stably form films having favorable characteristics. The $Al_2O_3$ sputtering target of the present invention is effective for forming semiconductor elements such as gate insulation films, masks, and etch stoppers.

**Claims**

1. An $Al_2O_3$ sputtering target having a purity of 99.99 wt% or higher, a relative density of 85% or higher and 95% or less, a volume resistivity of $10 \times 10^{14}$ Ω•cm or less, and a dielectric tangent of $15 \times 10^{-4}$ or more.

**2.** The Al$_2$O$_3$ sputtering target according to claim 1, wherein the Al$_2$O$_3$ sputtering target has an average crystal grain size of 0.3 to 3.0 μm.

**3.** The Al$_2$O$_3$ sputtering target according to claim 1 or claim 2, wherein the Al$_2$O$_3$ sputtering target has a surface roughness Ra of 1.0 to 2.0 μm.

**4.** The Al$_2$O$_3$ sputtering target according to any one of claims 1 to 3, wherein the Al$_2$O$_3$ sputtering target has a transverse intensity of 200 MPa or more.

**5.** The Al$_2$O$_3$ sputtering target according to any one of claims 1 to 4, wherein, when a target is placed in a sputtering device equipped with an RF power source and a film is deposited under conditions of an input power of 2.5 to 3.0 W/cm$^2$, an Ar partial pressure of 0.5 Pa, and a film thickness of 500 Å, a deposition rate is 4.0 Å/second or more.

**6.** The Al$_2$O$_3$ sputtering target according to any one of claims 1 to 5, wherein, when a target is placed in a sputtering device equipped with an RF power source and a film is deposited under conditions of an input power of 2.5 to 3.0 W/cm$^2$, an Ar partial pressure of 0.5 Pa, and a film thickness of 500 Å, a burn-in time is within 200 kwh.

**7.** The Al$_2$O$_3$ sputtering target according to any one of claims 1 to 6, wherein, when a target is placed in a sputtering device equipped with an RF power source and a film is deposited on a wafer having a diameter of 300 mm under conditions of an input power of 2.5 to 3.0 W/cm$^2$, an Ar partial pressure of 0.5 Pa, and a film thickness of 500 Å, a number of particles exceeding 0.12 μm existing on a wafer is less than 100 particles.

**8.** The Al$_2$O$_3$ sputtering target according to any one of claims 1 to 7, wherein, when a target is placed in a sputtering device equipped with an RF power source and a film is deposited on a wafer having a diameter of 300 mm under conditions of an input power of 2.5 to 3.0 W/cm$^2$, an Ar partial pressure of 0.5 Pa, and a film thickness of 500 Å, a film thickness variation (σ) in 49 in-plane points of the wafer is 30 Å or less.

**9.** The Al$_2$O$_3$ sputtering target according to any one of claims 1 to 8, wherein, when a target is placed in a sputtering device equipped with an RF power source and a film is deposited on a wafer having a diameter of 300 mm under conditions of an input power of 2.5 to 3.0 W/cm$^2$, an Ar partial pressure of 0.5 Pa, and a film thickness of 500 Å, an etching rate of dry etching performed to the film is 20 nm/min or less.

**10.** A production method of an Al$_2$O$_3$ sputtering target, wherein an Al$_2$O$_3$ raw material powder having a purity of 99.99 wt% or higher is hot pressed to prepare a compact having a relative density of 60% or higher and 85% or less, and the compact is subject to pressureless sintering.

**11.** The production method of an Al$_2$O$_3$ sputtering target according to claim 10, wherein the pressureless sintering is performed at a temperature range t which satisfies $T \leq t \leq T + 600°C$ (wherein T is a hot press temperature).

**12.** The production method of an Al$_2$O$_3$ sputtering target according to claim 10 or claim 11, wherein the hot press temperature is set to 800°C to 1400°C.

**13.** The production method of an Al$_2$O$_3$ sputtering target according to any one of claims 10 to 12, wherein an Al$_2$O$_3$ raw material powder having an average grain size of 0.1 to 0.3 μm is used.

**14.** The production method of an Al$_2$O$_3$ sputtering target according to any one of claims 10 to 13, wherein, after pressureless sintering, a surface of the obtained sintered body is roughened via rough grinding or blast treatment.

[FIG. 1]

[FIG. 2]

## INTERNATIONAL SEARCH REPORT

| International application No. |
| --- |
| PCT/JP2017/043730 |

**A. CLASSIFICATION OF SUBJECT MATTER**
Int.Cl. C23C14/34(2006.01)i, C04B35/111(2006.01)i

According to International Patent Classification (IPC) or to both national classification and IPC

**B. FIELDS SEARCHED**

Minimum documentation searched (classification system followed by classification symbols)
Int.Cl. C23C14/34, C04B35/111

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2013/065337 A1 (FERROTEC CERAMICS CORPORATION) 10 May 2013, claims 1, 14, paragraph [0039] & US 2015/0122642 A1, claims 1, 7, paragraph [0038] & CN 103917688 A & KR 10-2014-0073570 A & TW 201319286 A | 1–14 |
| A | JP 10-298743 A (TOSOH CORP.) 10 November 1998, claim 1 & US 6074279 A1, claim 1 & TW 381123 B | 10–14 |

☐ Further documents are listed in the continuation of Box C.     ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 14 February 2018 (14.02.2018) | 27 February 2018 (27.02.2018) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000064034 A
- WO 2013065337 A